# EUROPÄISCHE PATENTSCHRIFT

(11) **EP 0 560 261 B1**
(45) Veröffentlichungstag und Bekanntmachung des Hinweises auf die Patenterteilung: **31.05.1995**
(21) Anmeldenummer: 93103690.9
(22) Anmeldetag: 08.03.1993
(51) Int. Cl.: H05K 7/14

(54) **Vorrichtung zum Festlegen von Schaltungsplatinen in einem Gerätegehäuse**
Device for fastening of circuit boards inside a casing
Dispositif pour le maintien de plaques de circuit dans un boîtier

(30) Priorität: 10.03.1992 DE 4207572
(43) Veröffentlichungstag der Anmeldung: 15.09.1993
(73) Patentinhaber: Siemens Nixdorf Informationssysteme Aktiengesellschaft, 33102 Paderborn (DE)
(72) Erfinder: Reichert, Ingo, W-1000 Berlin 65 (DE)
(74) Vertreter: Fuchs, Franz-Josef, Dr.-Ing.

(56) Entgegenhaltungen:
- EP-A- 0 425 184
- IBM TECHNICAL DISCLOSURE BULLETIN. Bd. 20, Nr. 7, Dezember 1977, New York,US;Seiten 2794 - 2796; J.L. NEUBAUER: "Lectronic card retainer unit"

## Beschreibung

Die Erfindung betrifft eine Vorrichtung zum Festlegen einer Mehrzahl von Schaltungsplatinen in einem Gerätegehäuse, wobei die Schaltungsplatinen jeweils an einem ihrer Ränder mit einer senkrecht zur Platinenebene gerichteten streifenförmigen Metallblende verbunden sind, die jeweils an einem ihrer Längsenden einen rechtwinklig abgebogenen Flansch hat, und wobei die Schaltungsplatinen parallel zueinander so in das Gehäuse einsteckbar sind, daß die Metallblenden einerseits und ihre Flansche andererseits jeweils in einer Ebene liegen.

In allen bekannten PC's (Personal Computers) und PC-ähnlichen Geräten werden die elektronischen Schaltungsplatinen oder Steckkarten über Randkarten mit dem Zentralprozessor (CPU) verbunden. Die Schnittstellen (in der Regel D-sub-Steckdosen) zum jeweiligen Steckeranschluß an die Steckkarte befinden sich auf einer der oben genannten Metallblenden, die wiederum im Gerät mit einer Schraube metallisch leitend mit dem Gerätegehäuse verbunden wird.

Bei der vorstehend beschriebenen herkömmlichen Lösung müssen beim Einsetzen und Wechseln der elektronischen Steckkarten jeweils eine oder mehrere Schrauben eingeschraubt oder gelöst werden. Neben dem damit verbundenen Aufwand hat dies den weiteren Nachteil, daß immer wieder Schrauben in das Gerät fallen. Diese können zu Kurzschlüssen und damit zu Schäden am Gerät führen. Zumindest ist jedoch häufig ein erheblicher Aufwand notwendig, um die Schrauben wieder zu entfernen.

Der Erfindung liegt die Aufgabe zugrunde, eine leicht und sicher zu handhabende Vorrichtung der eingangs genannten Art anzugeben, mit der die Steckkarten und Blenden zuverlässig festgelegt werden können unter gleichzeitiger Gewährleistung eines elektrischen Kontaktes zwischen den Metallblenden und dem Gehäuse.

Diese Aufgabe wird erfindungsgemäß durch einen metallischen Haltebügel gelöst, der sich zwischen den parallel zu den Platinen gerichteten Gehäusewänden senkrecht zu diesen der über die Flansche der Metallblenden erstreckt, mit dem Gehäuse form- und/oder kraftschlüssig verbindbar ist und zur Anlage an den einzelnen Flanschen bestimmte Federelemente hat.

Mit diesem Haltebügel können sämtliche Steckkarten in einem einzigen Arbeitsgang freigegeben oder festgelegt werden. Das Lösen oder Einsetzen von Schrauben an den einzelnen Blenden ist nicht erforderlich. Die Federelemente an dem Haltebügel gewährleisten einen guten elektrischen Kontakt zwischen den einzelnen Metallblenden und dem Gehäuse.

Vorzugsweise ist der Haltebügel von einer U-Profilschiene aus Federstahl gebildet, aus deren zur Anlage an den Flanschen bestimmten U-Quersteg Federzungen ausgestanzt sind, die im offenen Zustand des Haltebügels aus der Ebene des U-Quersteges schräg nach außen gebogen sind. Damit vereinfacht sich die Herstellung des Haltebügels. Beim Schließen des Haltebügels werden die Federelemente in die Ebene des U-Quersteges zurückgedrückt, wobei sie auf der Oberfläche der Flansche entlangkratzen und dabei einen zuverlässigen elektrischen Kontakt zwischen dem Haltebügel und den Metallblenden schaffen.

Zur Verbindung des Haltebügels mit dem Gehäuse wird erfindungsgemäß vorgeschlagen, daß der Haltebügel an seinem einen Längsende eine Zunge zum Einstecken in einen Schlitz in einer der Gehäusewände und an seinem anderen Längsende eine Federklammer trägt, die zum Eingriff mit einer Gehäusekante bestimmt ist. Damit kann der Haltebügel an dem Gehäuse festgelegt werden, ohne daß hierzu separate Befestigungselemente erforderlich wären.

Vorzugsweise ist die Federklammer aus einem Verlängerungsabschnitt des U-Quersteges gebogen mit einem ersten Schenkel, der senkrecht zum U-Quersteg nach der Seite hin gerichtet ist, nach der auch die Federzungen weisen, und mit einem U-förmig zurückgebogenen zweiten Schenkel, der länger als der erste Schenkel ist und an seinem freien Ende einen abgewinkelten Griffabschnitt hat, wobei in einer zu den Flanschen der Metallblende parallelen gehäusefesten Fläche eine Aussparung vorgesehen ist, in welche die Federklammer unter Zusammendrücken der beiden Schenkel einsteckbar ist. Beim Einsetzen und Festlegen des Haltebügels wird dieser also mit der Zunge in den Schlitz in der Gehäusewand eingesteckt, um diese Zunge herum verschwenkt, bis die U-Profilschiene auf den Flanschen der Metallblenden aufliegt, wobei die Federklammer in die Aussparung der gehäusefesten Fläche eingedrückt wird. Durch einfaches Ziehen an dem Griffabschnitt der Federklammer kann der Haltebügel wieder gelöst werden. Vorzugsweise sind bei dieser Anordnung die Federzungen derart ausgestanzt, daß sie mit ihren freien Enden von dem mit der Zunge versehenen Längsende des Haltebügels wegweisen. Dies bewirkt, daß die Federzungen beim Verschwenken des Haltebügels auf den Flanschen der Metallblenden entlang schaben und sich in das Material eingraben.

Die vorstehende Beschreibung zeigt, daß mit einem einzigen Griff die elektrische und mechanische Verbindung aller Blenden mit dem Gehäuse hergestellt oder gelöst werden kann. Gleichzeitig ist die Gefahr ausgeschlossen, daß einzelne Befestigungselemente in das Gerät fallen und zu den oben beschriebenen Schäden führen können.

Die folgende Beschreibung erläutert in Verbindung mit den beigefügten Zeichnungen die Erfindung anhand eines Ausführungsbeispieles. Es zeigen:
- Figur 1: eine schematische Draufsicht auf einen erfindungsgemäßen Haltebügel,
- Figur 2: eine Seitenansicht des Haltebügels in Richtung des Pfeiles A in Figur 1 und
- Figur 3: eine schematische Rückansicht eines Gerätegehäuses mit eingesteckten Schaltungsplatinen und Metallblenden, wobei der Haltebügel in geschlossener und geöffneter Stellung dargestellt ist.

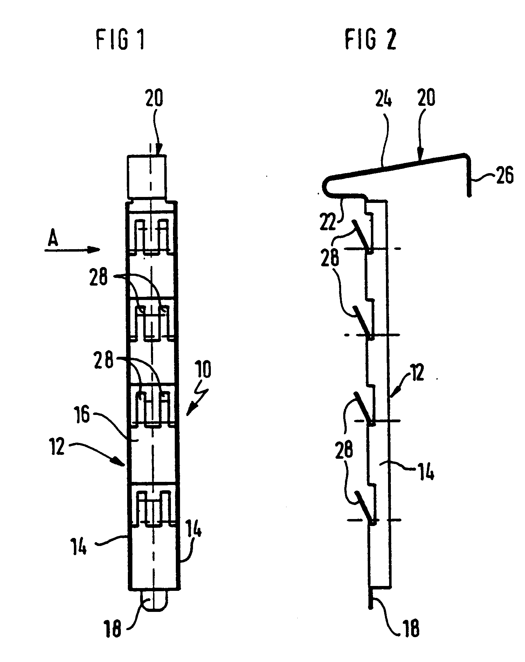

Der in den Figuren 1 und 2 dargestellte Haltebügel 10 besteht im wesentlichen aus einer U-Profilschiene 12 aus Federstahl mit U-Schenkeln 14 und einem U-Quersteg 16. An seinem einen Längsende hat der U-Quersteg 16 eine einstückig mit ihm ausgebildete Zunge 18. An seinem entgegengesetzten Ende ist ein Verlängerungsabschnitt des U-Quersteges 16 zu einer Federklammer 20 gebogen. Diese umfaßt einen ersten Federschenkel 22, der von U-Quersteg 16 senkrecht nach der zur Erstreckungsrichtung der U-Schenkel 14 entgegengesetzten Seite umgebogen ist, und einen U-förmig zurückgebogenen, gegenüber dem Federschenkel 22 längeren zweiten Federschenkel 24, der an seinem freien Ende einen abgewinkelten Griffabschnitt 26 hat.

Aus dem U-Quersteg 16 sind jeweils Paare von Federzungen 28 ausgestanzt, die aus der Ebene des U-Querschenkels 16 schräg nach außen abgewinkelt sind, wie dies in Figur 2 zu erkennen ist.

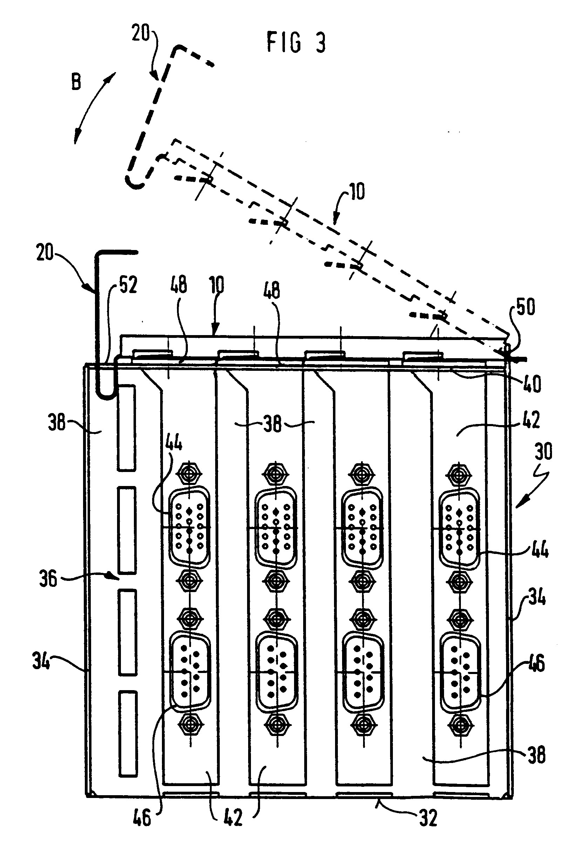

Figur 3 zeigt in schematischer Weise ein Gerätegehäuse 30 zur Aufnahme von nicht dargestellten elektronischen Schaltungsplatinen. Das Gehäuse 30 umfaßt einen Boden 32, Seitenwände 34 und eine gitterförmige Rückwand 36, die im vorliegenden Beispiel mit dem Boden 32 zusammenhängt und eine Anzahl von parallel zu den Seitenwänden 34 gerichteten Streben 38 umfaßt, die an ihrem dem Boden 32 fernen Ende durch einen rechtwinklig nach außen umgebogenen Steg 40 miteinander verbunden sind. In dieses Gehäuse werden die nicht dargestellten Schaltungsplatinen so eingesteckt, daß sie parallel zu den Seitenwänden 34 gerichtet sind. Mit jeder der Schaltungsplatinen ist über Randstecker eine Metallblende 42 verbunden, deren Fläche senkrecht zur Ebene der jeweiligen Schaltungsplatine gerichtet ist. Die Metallblenden 42 tragen jeweils Stecker 44, 46 zur Verbindung der Schaltungsplatinen mit anderen Teilen des Gerätes oder externen Geräten.

Die Anordnung der Schaltungsplatinen in dem Gerätegehäuse 30 ist so getroffen, daß die Blenden 42 mit ihren Steckern 44, 46 in den Lücken zwischen je zwei Streben 38 der Rückwand 36 liegen. Die Blenden 42 haben jeweils einen rechtwinklig abgebogenen Flansch 48, der bei vollständig eingesteckter Steckkarte auf dem Steg 40 der Rückwand 36 aufliegt. Bisher wurde dieser Flansch 48 jeweils mit dem Steg 40 verschraubt. Bei der in Figur 3 dargestellten Lösung jedoch erfolgt das Festlegen der Metallblenden 42 und damit auch der Steckkarten in dem Gehäuse 30 mit Hilfe des anhand der Figuren 1 und 2 beschriebenen Haltebügels 10. Dieser ist in Figur 3 durch ausgezogene Linien in seiner geschlossenen Stellung und durch gestrichelte Linien in einer geöffneten Stellung dargestellt. Der Haltebügel wird mit der Zunge 18 in einen Schlitz 50 der in der Figur 3 rechten Seitenwand 34 eingesteckt und kann dann in Richtung des Doppelpfeiles B in Figur 3 verschwenkt werden. Zum Schließen des Haltebügels 10 wird dieser nach unten gegen die Flansche 48 der Metallblenden 42 gedrückt, wobei die Federzungen 28 in die Ebene des U-Quersteges 16 des Haltebügels 10 zurückgedrückt werden und dabei sich in das Material der Flansche 48 eingraben. Die Sicherung des Haltebügels 10 in der durch ausgezogene Linien wiedergegebenen Schließstellung erfolgt durch das Einstecken der Federklammer 20 in eine Aussparung 52 in dem Steg 40 der Gehäuserückwand 36. Dabei werden die Federschenkel der Federklammer 20 zusammengedrückt, so daß sie unter Druck an den Rändern der Aussparung 52 anliegen und damit den Haltebügel 10 in der Schließstellung sichern. Durch einfaches Ziehen an dem Griffabschnitt 26 kann der Haltebügel 10 von den Flanschen 48 weggeschwenkt und damit die Verbindung der Metallblenden 42 mit dem Gehäuse 30 gelöst werden. Auf diese Weise kann das Auswechseln von Steckkarten rasch und bequem erfolgen, ohne daß die Gefahr besteht, daß Befestigungselemente in das Gerät fallen können.

## Patentansprüche

1. Vorrichtung zum Festlegen einer Mehrzahl von Schaltungsplatinen in einem Gerätegehäuse (30), wobei die Schaltungsplatinen jeweils an einem ihrer Ränder mit einer senkrecht zur Platinenebene gerichteten streifenförmigen Metallblende (42) verbunden sind, die an einem ihrer Längsenden einen rechtwinklig abgebogenen Flansch (48) hat, und wobei die Schaltungsplatinen parallel zueinander so in das Gehäuse (30) einsteckbar sind, daß die Metallblenden (42) einerseits und ihre Flansche (48) andererseits jeweils in einer Ebene liegen, **gekennzeichnet** durch einen metallischen Haltebügel (10), der sich zwischen den parallel zu den Platinen gerichteten Gehäusewänden (34) senkrecht zu diesen quer über die Flansche (48) der Metallblenden (42) erstreckt, mit dem Gehäuse (30) form- und/oder kraftschlüssig verbindbar ist und zur Anlage an den einzelnen Flanschen (48) bestimmte Federelemente (28) hat.

2. Vorrichtung nach Anspruch 1, dadurch **gekennzeichnet**, daß der Haltebügel (10) von einer U-Profilschiene (12) aus Federstahl gebildet ist, aus deren zur Anlage an den Flanschen (48) bestimmten U-Quersteg (16) Federzungen (28) ausgestanzt sind, die im offenen Zustand des Haltebügels (10) aus der Ebene des U-Quersteges (16) schräg nach außen gebogen sind.

3. Vorrichtung nach Anspruch 1 oder 2, dadurch **gekennzeichnet**, daß der Haltebügel (10) an seinem einen Längsende eine Zunge (18) zum Einstecken in einen Schlitz (50) in einer der Gehäusewände (34) und an seinem anderen Längsende eine Federklammer (20) trägt, die zum Eingriff mit einer gehäusefesten Kante bestimmt ist.

4. Vorrichtung nach Anspruch 3, dadurch **gekennzeichnet**, daß die Federzungen (28) derart ausgestanzt sind, daß sie mit ihren freien Enden von dem mit der Zunge (18) versehenen Längsende des Haltebügels (10) wegweisen.

5. Vorrichtung nach einem der Ansprüche 2 bis 4, dadurch **gekennzeichnet**, daß die Federklammer (20) aus einem Verlängerungsabschnitt des U-Quersteges (16) gebogen ist mit einem ersten Schenkel (22), der senkrecht zum U-Quersteg (16) nach der Seite hin gerichtet ist, nach der auch die Federzungen (28) weisen, und mit einem U-förmig zurückgebogenen zweiten Schenkel (24), der länger als der erste Schenkel (22) ist und an seinem freien Ende einen abgewinkelten Griffabschnitt (26) hat, wobei an einer zu den Flanschen (48) der Metallblenden (42) parallelen gehäusefesten Fläche (40) eine Aussparung (52) vorgesehen ist, in welche die Federklammer (20) unter Zusammendrücken ihrer beiden Schenkel (22, 24) einsteckbar ist.

## Claims

1. Device for fixing a plurality of circuit boards in an apparatus housing (30), the circuit boards each being connected on one of their edges to a metal panel (42) which is in the form of a strip, is directed at right angles to the board plane and has on one of its longitudinal ends a flange (48) which is bent out at right angles, it being possible to insert the circuit boards into the housing (30) parallel to one another such that the metal panels (42) on the one hand and their flanges (48) on the other hand in each case lie in a plane, characterized by a metallic retaining bracket (10) which extends between the housing walls (34), which are directed parallel to the boards, at right angles thereto and transversely over the flanges (48) of the metal panels (42), can be connected to the housing (30) in a positively locking and/or force-fitting manner, and has spring elements (28) which are intended to rest on the individual flanges (48).

2. Device according to Claim 1, characterized in that the retaining bracket (10) is formed from a U-profiled rail (12) made of spring steel, out of whose U-transverse web (16), which is intended to rest on the flanges (48), spring tongues (28) are stamped which, when the retaining bracket (10) is in the open state, are bent obliquely outwards from the plane of the U-transverse web (16).

3. Device according to Claim 1 or 2, characterized in that the retaining bracket (10) has on its one longitudinal end a tongue (18) for insertion into a slot (50) in one of the housing walls (34) and, on its other longitudinal end, a spring bracket (20) which is intended to engage with an edge which is fixed to the housing.

4. Device according to Claim 3, characterized in that the spring tongues (28) are stamped in such a manner that their free ends point away from that longitudinal end of the retaining bracket (10) which is provided with the tongue (18).

5. Device according to one of Claims 2 to 4, characterized in that the spring bracket (20) is bent out of an extension section of the U-transverse web (16), having a first limb (22) which is directed at right angles to the U-transverse web (16) towards the side towards which the spring tongues (28) also point, and having a second limb (24), which is bent back in a U-shape, is longer than the first limb (22) and has a gripping section (26), which is bent outwards, on its free end, a cutout (52) being provided on a surface (40) which is fixed to the housing and is parallel to the flanges (48) of the metal panels (42), into which cutout the spring bracket (20) can be inserted, with its two limbs (22, 24) being compressed.

## Revendications

1. Dispositif pour fixer une multiplicité de platines portant les circuits, dans un boîtier d'appareil (30) , et dans lequel les platines portant les circuits sont reliées respectivement au niveau de leurs bords, à un panneau métallique en forme de bande (42) dirigé perpendiculairement au plan de la platine et qui possède, au niveau de ses extrémités longitudinales, une bride repliée à angle droit (48), et dans lequel les platines portant les circuits peuvent être enfichées parallèlement entre elles dans le boîtier (3) de telle sorte que les panneaux métalliques (42), d'une part, et leurs brides (48), d'autre part, sont situés respectivement dans un plan, caractérisé par un étrier métallique de retenue (10), qui s'étend entre les parois (34) du boîtier qui sont parallèles aux platines, perpendiculairement à ces parois et transversalement au-dessus des brides (48) des panneaux métalliques (42), peut être relié au boîtier (30) selon une liaison par formes complémentaires et/ou selon une liaison de force et comporte des éléments de ressort (28) destinés à s'appliquer sur les différentes brides (48).

2. Dispositif suivant la revendication 1, caractérisé par le fait que l'étrier de retenue (10) est formé par un rail profilé en U (12), réalisé en un acier pour ressorts et qu'à partir de la barrette transversale en U (16) de ce rail, qui est destinée à s'appliquer contre les brides (48), sont découpées des languettes élastiques (28) qui, lorsque l'étrier de retenue (10) est à l'état ouvert, sont repliées obliquement vers l'extérieur, à partir du plan de la barrette transversale en U (16).

3. Dispositif suivant la revendication 1 ou 2, caractérisé par le fait que l'étrier de retenue (10) porte, à l'une de ses extrémités longitudinales, une languette (18) destinée à être enfichée dans une fente (50) ménagée dans l'une de parois (34) du boîtier et, au niveau de son autre extrémité longitudinale, une pince élastique (20), qui est destinée à coagir avec un bord solidaire du boîtier.

4. Dispositif suivant la revendication 3, caractérisé par le fait que les languettes élastiques (28) sont découpées de telle sorte que leurs extrémités libres s'écartent de l'extrémité longitudinale de l'étrier de retenue (10), qui est pourvue de la languette (18).

5. Dispositif suivant l'une des revendications 2 à 4, caractérisé par le fait que la pince élastique (20) est repliée à partir d'une section de prolongement de la barrette transversale en U (16), avec une première branche (22), qui est dirigée perpendiculairement à la barrette transversale en U (16) vers le côté, vers lequel sont également dirigées les languettes élastiques (28), et avec une seconde branche (24) repliée en arrière en forme de U et qui est plus longue que la première branche (22) et possède, sur son extrémité libre, une partie coudée de préhension (26), un évidement (52), dans lequel la pince élastique (20) peut être enfichée moyennant une compression de ses deux branches (22,24), étant prévu dans une surface (40) solidaire du boîtier et parallèle aux brides (48) du panneau métallique (42).
